# EUROPEAN PATENT APPLICATION

(11) **EP 4 542 417 A1**
(43) Date of publication of application: **23.04.2025**
(21) Application number: 24207515.8
(22) Date of filing: 18.10.2024
(51) Int. Cl.: G06F 16/3329

(54) **ARTIFICIAL INTELLIGENCE DIGITAL ASSISTANT THAT RETRIEVES AND CONSOLIDATES DATA FROM DIVERSE SOURCES**

(30) Priority: 20.10.2023 US 202363545129 P
(71) Applicant: AVEVA Software, LLC, Lake Forest, CA 92630 (US)
(72) Inventor: Bielke, William, Lake Forest, 92630 (US); Kamath, Vinay T., Lake Forest, 92630 (US); Erickson, Brian, Lake Forest, 92630 (US); Traupel, Willem, Lake Forest, 92630 (US)
(74) Representative: WBH Wachenhausen Patentanwälte PartG mbB

(57) **Abstract**

An artificial intelligence digital assistant that retrieves and consolidates data from diverse sources is described. After a system initiates a response to an information request received from a user, a language model generates a high-dimensional vector that represents the information request from the user. The language model identities data access tools that access corresponding data types identified for the information request. The system executes the identified data access tools that retrieve, from corresponding data sources, data values from corresponding data records represented by corresponding unique high-dimensional vectors that have similarities, which exceed a confidence level, to the high-dimensional vector that represents the information request. The system sends a consolidation of the data values in the response to the user.

## Description

### CROSS REFERENCE TO RELATED APPLICATION

This application claims priority under 35 U.S.C. § 119 or the Paris Convention from U.S. Provisional Patent Application 63/545,129, filed October 20, 2023, the entire contents of which is incorporated herein by reference as if set forth in full herein.

### BACKGROUND

In industrial settings, the efficient and accurate retrieval and consolidation of data from diverse sources is paramount for informed decision-making and process optimization. However, traditional industrial systems encounter several challenges leading to inefficiencies and hindered data-driven insights. Industrial sites generate an abundance of data from diverse sources, including sensors, machinery, and control systems. This data is often fragmented, distributed across distinct platforms, and may exist in varying formats, making it arduous to centralize and consolidate.

Retrieving data from these diverse sources typically necessitates manual intervention. Operators, engineers, and/or data analysts engage in a labor-intensive process, accessing multiple systems individually to gather the requisite data. This manual approach is time-consuming and error prone. The presence of data silos within industrial organizations further complicates the consolidation process. Data silos restrict the free flow of information and often lead to data redundancy, making cross-functional data consolidation a challenging endeavor.

Manual data consolidation is susceptible to human error. Data entry mistakes, misinterpretation of data sources, and omissions can introduce inaccuracies and compromise the reliability of consolidated data. Absent advanced data management and quality control mechanisms, inconsistencies in data quality are prevalent. Varied units of measurement, formatting discrepancies, and data inaccuracies can also undermine the integrity of consolidated data and subsequent analyses.

Real-time access to data is also constrained by manual processes, causing delays in responding to changing operational conditions. Manual data consolidation consumes valuable time and resources, leaving limited room for in-depth data analysis and insight generation. This constrains organizations in making informed, data-driven decisions and optimizing their processes. As industrial operations expand and generate ever-increasing volumes of data, manual consolidation becomes less tenable. Scalability challenges emerge, hindering the efficient handling of large datasets from diverse sources.

### BRIEF DESCRIPTION OF THE DRAWINGS

FIG. 1 illustrates example architecture of a system for an artificial intelligence digital assistant that retrieves and consolidates data from diverse sources, according to some embodiments.
FIG. 2 depicts initiating an example chatbot session for an artificial intelligence digital assistant that retrieves and consolidates data from diverse sources, according to some embodiments.
FIG. 3 illustrates example retrieved and consolidated documents links in response to a user request for an artificial intelligence digital assistant that retrieves and consolidates data from diverse sources, according to some embodiments.
FIG. 4 depicts an example document displayed in response to a user selection of a link for an artificial intelligence digital assistant that retrieves and consolidates data from diverse sources, according to some embodiments.
FIG. 5 illustrates example dashboard links retrieved and displayed in response to a user information request for an artificial intelligence digital assistant that retrieves and consolidates data from diverse sources, according to some embodiments.
FIG. 6 depicts an example summarization of performance for an asset for artificial intelligence digital assistant that retrieves and consolidates data from diverse sources, according to some embodiments.
FIG. 7 illustrates example visualizations of data in a chat graphical user interface for an artificial intelligence digital assistant that retrieves and consolidates data from diverse sources, according to some embodiments.
FIG. 8 depicts an example chart displayed in a chat graphical user interface for an artificial intelligence digital assistant that retrieves and consolidates data from diverse sources, according to some embodiments.
FIG. 9 illustrates a block diagram of an example system for an artificial intelligence digital assistant that retrieves and consolidates data from diverse sources, according to some embodiments.
FIG. 10 depicts a flowchart of an example computer-implemented method for an artificial intelligence digital assistant that retrieves and consolidates data from diverse sources, according to some embodiments.
FIG. 11 is a block diagram illustrating an example hardware device in which the subject matter may be implemented.

### DETAILED DESCRIPTION

There is an unmet need in the industry for systems and methods that enable a digital assistant to semantically analyze a user's information request to identify different types of requested data and retrieve the data, in a consolidated format, from diverse data sources. Examples of diverse data sources include manufacturing execution system (MES) data, documents, time series data, process historian databases, simulations (digital twin/asset models), engineering data, customer defined contents (such as custom dashboards), event-based data, asset information management data, and any other types of asse data. This disclosure is directed to an artificial intelligence (AI) digital assistant that manages multiple processes which retrieve data from diverse sources, and consolidates the data into a response, which may be displayed in a chat window.

In the industrial and manufacturing fields, diverse data sources are not directly linked by a single platform. Therefore, the digital assistant provides a novel approach to requesting, searching, retrieving, and/or consolidating data from diverse sources in response to a single information request. The system enriches the data sources using a combination of semantic information and vector embeddings that identify each of the individual data records. These vector embeddings enable the digital assistant to take small, generalized phrases as inputs for one or more language models that understand the context and objectives of a user's information request, and then generate a vector embedding that represents the information request as a high-dimensional vector that is similar to the high-dimensional vectors that represent relevant data records. Consequently, the digital assistant does not need a knowledge graph to determine a relationship between the requested data and the data's sources.

The digital assistant uses one or more language models with goal planning to execute multi-step transactions to retrieve and mix industrial data from various sources to dynamically answer users' information requests. The digital assistant enables a user to ask questions about a component and/or a process in an industrial system without the digital assistant having any previous knowledge of the exact name of the component or processes' specific data records. For example, a user's information request such as "provide me a status for pump 3" could result in a response that includes various tags, maintenance history, and statistical analysis that may not be explicitly linked to and/or labeled as "pump 3." There is no need for a knowledge graph with explicit links between different data sources due to the digital assistant's ability to semantically analyze a user's information request.

The system has one or more data access tools that the one or more language models use to retrieve supporting data for a response. The digital assistant uses the one or more language models to generate and critique a plan about which data access tools should be used to properly handle a user's information request. The digital assistant uses the results from the one or more language models to determine which data access tools to execute. After executing the data access tools, the digital assistant can summarize the data access tools' responses and pass the summarized responses back to the one or more language models for continued processing to generate a final response. Once the final response is completed, the digital assistant sends the final response to the user.

The final response uses a format that enables the digital assistant to adorn, enrich, and/or enhance the response data with visualizations, such as charts, statistical analysis, other graphical representations, and/or visualization links (such as hyperlinks) that lead to one or more data sources. The final response may include generated text that explains the relationship and/or the source of the one or more visualizations. The digital assistant can summarize data from multiple data sources within the context of the user's information request. The final response may also include additional supporting information not explicitly identified in the user's information request.

Embodiments provide an artificial intelligence digital assistant that retrieves and consolidates data from diverse sources. After a system initiates a response to an information request received from a user, a language model (e.g., text embedding model) generates a high-dimensional vector that represents the user's information request. The language model identities data access tools that access corresponding data types identified for the information request. The system executes the identified data access tools that retrieve, from corresponding data sources, data values from corresponding data records represented by corresponding unique high-dimensional vectors that have similarities, which exceed a confidence level, to the high-dimensional vector that represents the information request. The system sends a consolidation of the data values in the response to the user.

For example, an artificial intelligence digital assistant receives a request "What is the performance of pump 3 over the last month?" from a chat session for a user named Bill, and uses a language model to generate the vector [-5.2, +3.1, +0.2. +8.1, +3.5, ... ] that represents Bill's information request. A Large Language Model, such as GPT-4o or similar models, uses Bill's history of previous requests for pump information which required historical operating speeds, temperatures, and pressures, alerts, and maintenance records to create a plan to execute tools to search and retrieve timeseries data, asset data, and event data. Then the digital assistant executes these tools to search timeseries data, asset data, and event data for unique vectors which are similar to the vector which represents Bill's information request. After identifying similar unique vectors in the data sources, such as the unique vector [-4.9, +3.6, +0.9. +7.8, +3.6, ... ] for a data record in the timeseries data, the tools retrieve the historical operating speeds, temperatures, and pressures, alerts, and maintenance records. The digital assistant displays charts and graphs which depict the historical operating speeds, temperatures, and pressures, alerts, and maintenance records in Bill's chat window.

Various embodiments and aspects of the disclosures will be described with reference to details discussed below, and the accompanying drawings will illustrate the various embodiments. The following description and drawings are illustrative of the disclosure and are not to be construed as limiting the disclosure. Numerous specific details are described to provide a thorough understanding of various embodiments of the present disclosure. However, in certain instances, well-known or conventional details are not described in order to provide a concise discussion of embodiments of the present disclosure.

Although these embodiments are described in sufficient detail to enable one skilled in the art to practice the disclosed embodiments, it is understood that these examples are not limiting, such that other embodiments may be used, and changes may be made without departing from their spirit and scope. For example, the operations of methods shown and described herein are not necessarily performed in the order indicated and may be performed in parallel. It should also be understood that the methods may include more or fewer operations than are indicated. Operations described herein as separate operations may be combined. Conversely, what may be described herein as a single operation may be implemented in multiple operations.

Reference in the specification to "one embodiment" or "an embodiment" or "some embodiments," means that a particular feature, structure, or characteristic described in conjunction with the embodiment may be included in at least one embodiment of the disclosure. The appearances of the phrase "an embodiment" or "the embodiment" in various places in the specification do not necessarily all refer to the same embodiment.

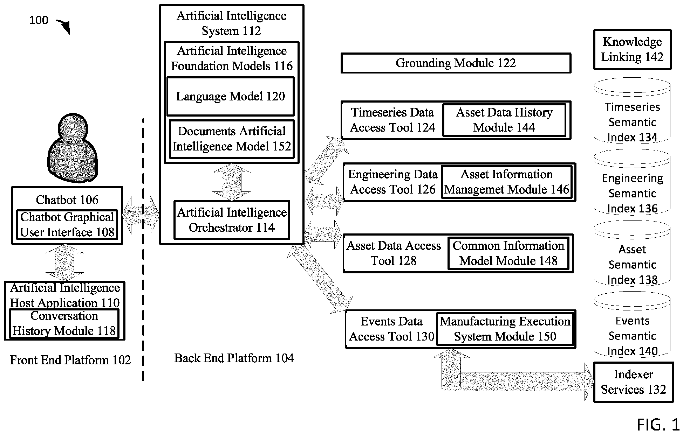

FIG. 1 illustrates an example architecture of the system **100** for an artificial intelligence digital assistant that retrieves and consolidates data from diverse sources, according to some embodiments. The system **100** includes a front-end platform **102** and a back-end platform **104.** The front-end platform **102** includes a chatbot **106** with a chatbot graphical user interface **108** powered by an artificial intelligence host application **110,** such as Aurora^{®}, which is commercially available from AVEVA. The artificial intelligence host application **110** on the front-end platform **102** manages and facilitates the conversation with users through the chatbot graphical user interface **108.** The chatbot graphical user interface **108** enables a user to enter text messages and/or commands, such as through text input fields for users to type messages, and/or areas to display the conversation history. The artificial intelligence host application **110** receives and/or transmits these user inputs to the back-end platform **104,** which includes an artificial intelligence system **112** with an artificial intelligence orchestrator **114** and/or artificial intelligence foundation models **116,** as further discussed below.

The artificial intelligence host application **110** can render messages and responses from the artificial intelligence system **112** onto the chatbot graphical user interface **108.** This includes displaying the responses generated by any artificial intelligence foundation models **116,** such as prompts, suggestions, and/or other relevant information, in a user-friendly format. The artificial intelligence host application **110** can use a conversation history module **118** to keep track of one or more portions of a conversation, and manage the conversation flow by ensuring that user messages are sent to the artificial intelligence system **112** and responses are displayed in the chatbot graphical user interface **108** in the correct order.

The artificial intelligence host application **110** can maintain the user's context and session state, ensuring that the chatbot **106** remembers past interactions and maintains a coherent conversation. In addition, the artificial intelligence host application **110** also includes features to enhance user interactions, such as buttons or quick replies that users click on to select predefined options, which help users navigate the conversation more easily and trigger specific actions. In addition to supporting text-based interactions, the artificial intelligence host application **110** can also support multimodal inputs, such as voice or images inputs. The artificial intelligence host application **110** may handle error messages or user feedback, forward user inputs, manage responses, and ensure that the chatbot graphical user interface **108** and the back-end platform **104's** artificial intelligence system **112** are tightly integrated.

The back-end platform **104** includes the artificial intelligence orchestrator **114** that can manage and/or control the interactions between users and the artificial intelligence system **112.** To ensure that the conversation remains coherent, safe, and goal-oriented, the artificial intelligence orchestrator **114** can determine how the conversation proceeds, what information to request from a user, and/or what responses to provide. The artificial intelligence orchestrator **114** executes natural language understanding (NLU) techniques to recognize user intents and extract relevant information from user messages, and link to one or more artificial intelligence foundation models **116** to generate one or more functions described herein.

The artificial intelligence orchestrator **114** can execute prompt injection, which is one or more techniques to guide or nudge the conversation with a user in a specific direction. The artificial intelligence orchestrator **114** inserts prompts or suggestions into the conversation with a user to encourage the user to provide certain information or take specific actions. For example, if a user is asking about the status update of a pump, the artificial intelligence orchestrator **114** injects prompts to ask for a specific timeframe or different parameters which have status information relating to the pump.

The artificial intelligence orchestrator **114** executes multi-step transactions by keeping track of the steps in the transaction, guiding the user through each step, and/or ensuring that all necessary information is collected. To ensure responsible and ethical use of artificial intelligence in a chat context, the artificial intelligence orchestrator **114** can implement one or more predefined rules, policies, and/or safety measures, which may be referred to as "guardrails." These guardrails help prevent the artificial intelligence from generating harmful or inappropriate content and ensure that the conversation remains within acceptable boundaries. The system **100** can use one or more guardrails to assist in maintaining compliance with regulations and/or organization policies. The artificial intelligence orchestrator **114** learns from user interactions, adapts orchestrator behavior over time, and improves intent recognition, conversation flow, and prompt injection strategies based on user feedback and data.

When responding to user information requests, the artificial intelligence orchestrator **114** can interact with application programming interfaces (APIs), external systems, and one or more artificial intelligence foundation models **116,** such as one or more language model **120.** When working in conjunction with one or more language model **120** (such as GPT-3 or similar models), the artificial intelligence orchestrator **114** can use these models as the artificial intelligence foundation models **116** to enhance their capabilities in a chat context. The combination of an artificial intelligence orchestrator **114** and one or more language model **120** provides the benefit of more dynamic and responsive conversations.

One or more language model **120** (any reference to a single artificial intelligence model such as a language model **120** is a reference to one or more models) are proficient at understanding and generating natural language text. The artificial intelligence orchestrator **114** uses a language model **120**'s natural language understanding (NLU) capabilities to interpret user messages, recognize user intents, and/or extract relevant information from a user conversation, which helps in determining what the user is asking or trying to achieve. The one or more language model **120** generate coherent and/or contextually relevant responses in natural language. The artificial intelligence orchestrator **114** uses the one or more language model **120** to compose responses that are engaging, informative, and appropriate to the user's queries or information requests, and ensure that the conversation flows smoothly.

When needed to guide the conversation or ask for specific information, the artificial intelligence orchestrator **114** uses the one or more language model **120** to craft prompts or suggestions. The one or more language model **120** have text generation capabilities to create prompts that encourage a user to provide necessary details, clarify their intentions, or move the conversation in the desired direction. In multi-step transactions, the artificial intelligence orchestrator **114** instructs the one or more language model **120** to remember and manage the context of the conversation. The one or more language model **120** assists in retaining information about the steps completed, a user's preferences, and the state of a transaction, which enables the artificial intelligence orchestrator **114** to seamlessly guide users through complex tasks where multiple pieces of information are required.

The one or more language model **120** use contextual adaptation to understand and adapt to the context of the conversation. The artificial intelligence orchestrator **114** uses the one or more language model **120** to keep track of previous messages, ensuring that user information requests are answered in a way that is consistent with the ongoing conversation, and inject personalized elements into the conversation. The one or more language model **120** generate responses that consider user preferences, past interactions, and/or historical data to make the conversation more tailored to the individual user. In cases where a user's intent is unclear, the artificial intelligence orchestrator **114** can use the one or more language model **120** to generate clarifying questions or suggestions. When encountering information requests or inputs that cannot be handled directly, the artificial intelligence orchestrator **114** can use the one or more language model **120** to generate appropriate fallback responses, which inform the user of the limitations of the system **100** or encourage them to rephrase their information request.

The artificial intelligence orchestrator **114** is linked to one or more data access tools **124** - **130,** which can access timeseries data, assets data, event data, and engineering data. The back-end platform **104** includes a grounding module **122** to connect and/or link information from one or more data access tools **124** - **130** to formulate common understanding that the artificial intelligence orchestrator **114** can work with. The artificial intelligence orchestrator **114** can send one or more queries and/or information requests in the back-end platform **104** to retrieve specific data from the data access tools **124** - **130.** For example, the artificial intelligence orchestrator **114** requests a time series data access tool **124** to provide historical information, an engineer data access tool **126** to get information about the people or teams involved with an asset or a service, an asset data access tool **128** to access details about products or services, and/or an event data access tool **130** to understand recent occurrences. After the data is retrieved, the artificial intelligence orchestrator **114** integrates the data into the conversation context.

The artificial intelligence orchestrator **114** can use the information from these data access tools **124 - 130** to respond to user information requests or provide recommendations. For example, when a user asks about the maintenance history of a particular asset, the artificial intelligence orchestrator **114** retrieves relevant asset data from the grounding module **122** and provides the user with accurate information. The artificial intelligence orchestrator **114** continuously and/or periodically monitors real-time events or status changes and/or updates the conversation with the changes. For example, when a user is tracking the status of a shipment, the artificial intelligence orchestrator **114** uses the event data access tool **130** to provide live updates substantially as they occur.

In the case of time series data, the artificial intelligence orchestrator **114** uses historical data for trend analysis, forecasts, or to provide insights to users. The artificial intelligence orchestrator **114** uses event data to notify users of significant events, such as system failures, maintenance alerts, and/or upcoming events. The system **100** sends alerts when specific conditions or thresholds are met in the event data, and access past data to help users understand patterns or make informed decisions. One or more of the data access tools **124 - 130** may be linked to an indexer service **132.** The artificial intelligence orchestrator **114** uses the indexer service **132** to search and retrieve data quickly from one or more data access tools **124** - **130,** and to organize and categorize data.

The system **100** uses one or more semantic indexes **134** - **140** for knowledge linking 142. Knowledge linking **142** includes the process of connecting or associating data and information from the different data access tools **124 - 130** and/or services. The artificial intelligence orchestrator **114** leverages the semantic indexes **134** - **140** to link knowledge across the data access tools **124 - 130** for timeseries, engineering, assets, and/or events data. The system **100** provides a holistic view of asset management, from historical performance data to engineering specifications, current asset status, and real-time events, and ensures that users receive comprehensive and context-aware responses.

Timeseries data represents historical data related to various assets and equipment. The timeseries semantic index **134** attached to the timeseries data tool **124** comprises metadata and/or information about time-series data, such as sensor readings, performance history, and/or other time-dependent data. The artificial intelligence orchestrator **114** uses this time series semantic index **134** to retrieve historical data on asset performance, track trends, and/or make informed decisions based on past data. An example timeseries data tool **124** includes an asset data history (ADH) module **144.**

Engineering data refers to information related to the design, specifications, and configurations of assets and/or equipment. The engineering semantic index **136** linked to the engineering data access tool **126** includes structured data (metadata) about assets, such as engineering drawings, schematics, and technical documentation. The artificial intelligence orchestrator **114** uses the engineering semantic index **136** to respond to user requests accurately by accessing engineering details, such as equipment specifications and maintenance requirements. An example engineering data access tool **126** includes an asset information management (AIM) module **146.**

The asset semantic index **138** associated with the asset data access tool **128** includes data (metadata) about assets, including their unique identifiers, locations, maintenance history, and/or other relevant details. The artificial intelligence orchestrator **114** use the asset semantic index **138** to identify assets, understand their status, and/or provide information about their current condition and/or historical data. An example asset data access tool **128** includes a common information model (CIM) module **148.**

An events data access tool **130** is associated with a manufacturing execution system (MES), which is used in manufacturing and industrial contexts to track and manage production processes. The events semantic index **140** attached to the events data access tool **130** includes information (metadata) about real-time events, alerts, and production updates. The artificial intelligence orchestrator **114** uses the events semantic index **140** to monitor and report on events, provide real-time alerts to users, and/or keep a user informed about the status of manufacturing processes. An example events data access tool **130** includes a manufacturing execution system (MES) module **150.**

The system **100** executes a combination of semantic search techniques to enable information in different systems to be linked dynamically based on similar attributes, without requiring specific linking data or the usage of same terminology between systems. Additionally, the system **100** executes a combination of semantic data and vector embeddings to enrich data from one or more databases. This enables the system **100** to take generalized phrases as inputs for the one or more language model **120** that understand the context and objectives of a user's information request, and then generate a vector embedding that represents the user's information request and is similar to the vector embeddings that represent relevant data.

Vector embedding, also known as vector representation or word embedding, includes one or more techniques used by the system **100** in natural language processing and machine learning to represent words, phrases, or documents as numerical vectors. The system **100** generates vectors to capture the semantic meaning and relationships between words, enabling the system **100** to process and understand textual data more effectively. The system **100** also generates one or more vector embeddings that provide distributed representations for words, where words with similar meanings or usages have similar vector representations.

Vector embeddings are created by the system **100** converting words or text into high-dimensional vectors in a continuous vector space. The system **100** assigns similar vector representations to words that are semantically similar or related. For example, in a trained word embedding model, the vectors for "king" and "queen" are closer in the vector space than the vectors for "king" and "apple.".

The vector embeddings include mathematical properties. The system **100** generates vector embeddings using mathematical techniques. For example, the system **100** links and/or employs algorithms such as Word2Vec, GloVe (Global Vectors for Word Representation), and/or FastText. The system **100** also executes one or more mathematical techniques and/or models to analyze text to learn word embeddings based on the co-occurrence patterns of words in sentences.

The system **100** can use word embeddings to perform word analogy tasks. For example, "king - man + woman" leads to a vector that is close to the representation of "queen." The system **100** uses word embeddings to capture contextual information by considering the surrounding words, allowing for more accurate word representations in context.

The system **100** uses vector embedding for sentiment analysis, text classification, machine translation, and/or named entity recognition. ELMo (Embeddings from Language Models) is an example of a linked system that executes word embedding. The system **100** can prompt a user to enter pretrained embeddings for use as a starting point in one or more tasks.

Vector embeddings generated by the system **100** are not limited to words alone. The system **100** can use vector embeddings for representing entire documents. The system **100** can execute one or more document artificial intelligence model **152** for document embedding or document representation. The one or more document artificial intelligence model **152** captures the semantic content and meaning of sentences, paragraphs, or documents, and then assigns a unique vector representation to each document in a collection.

The one or more document artificial intelligence model **152** execute a form of unsupervised learning where documents are treated as context for training. The one or more document artificial intelligence model **152** can learn to predict words in a document contextually, and the document vectors emerge as a result. The one or more document artificial intelligence model **152** determines the contextual meaning of words and phrases in a sentence by considering the entire sentence context using a bidirectional approach, wherein the one or more document artificial intelligence model **152** reads text from both directions (left to right and right to left), which captures the context of words and phrases more effectively.

The system **100** creates and/or uses common prompt descriptions for the one or more language model **120** to facilitate linking information between systems with different terminology. Creating common prompt descriptions includes creating a standardized and/or consistent language or vocabulary that can be understood by various systems or components. This normalized language acts as a bridge, translating different terms and concepts into a common format.

When different systems or tools communicate with one or more language model 120, they typically have their own specific terms or terminology for concepts, actions, or data. The use of common prompt descriptions enable these systems to respond to information requests or queries in a standardized format that the one or more language model **120** understands. Using common prompts enables the system **100** to achieve a higher level of interoperability.

Implementing common prompts enables different parts of a system or multiple systems to communicate effectively without being hindered by differences in language or terminology, which is beneficial in complex industrial environments where multiple systems need to work together. The common prompt descriptions help eliminate ambiguity or misunderstandings that may arise when different systems use different terms for the same concept. Common or standardized prompts enable the one or more language model **120** to interpret any user's input correctly and respond with such a user's intended actions or information.

The use of common prompts streamlines communication between systems. Common prompts reduce and/or eliminate the need for extensive mapping (such as a knowledge graph) or translation processes, making interactions more efficient thereby saving computer resources. In addition to generating common prompts to provide a standardized foundation for communication, the system **100** also adapts and/or extends the common prompts to specific use cases or industries. The system **100** can integrate the extended prompts while still accommodating domain specific terminology.

When different systems collect or manage data, common prompt descriptions assist in linking and integrating the different data seamlessly. The common prompts enable the one or more language model **120** to access and process information from various sources without being constrained by data silos. As an industrial setting grows and evolves, the use of common prompt descriptions facilitates scalability. Therefore, new systems or components can easily join the network and communicate with existing systems without significant integration challenges.

The one or more language model **120** generate plans or strategies for responding to user information requests, which include an outline of the steps and actions necessary to provide the required information or perform specific tasks, an identification of which data access tools **124 - 130** should be used to respond to the user request, and a suggestion of a sequence of interactions with the data access tools **124 - 130** which were identified to gather the data needed. After creating such a plan, the one or more language model **120** can generate a critique of the plan by assessing which of the data access tools **124 - 130** should be employed to respond to the user's request most effectively by considering the nature of the request, the type of data or information required, and/or the characteristics of the available data access tools **124** - **130.** The one or more language model **120** can suggest adjustments or alternative approaches if the originally proposed plan or tool selection is determined not to be the most efficient or a suitable option. The user does not need to have current access to all the data sources. The system **100** can act on the data available to the user and additional data sources can be added later.

The system **100** can augment contextual data for the one or more language model **120** by pre-fetching language based on either a user's information request and/or the information currently being viewed by the user. This additional information may be injected into a prompt for the one or more language model **120** to improve the accuracy and performance of the results. The system **100** can execute parallel information processing for structured data and language data. A unique combination of natural language information processing and structured data enables the one or more language model **120** to process information based on natural language representations while maintaining high-fidelity data for detailed information retrieval and analysis. The system **100** can return a collection of citations and supporting information from data sources used to create the blended result. The citations can be used independently of the chat text response.

The following example computer implemented steps in response to a user input are described in reference to the architecture of the system **100** as illustrated in FIG. 1 according to some embodiments. In response to a user's information request, "What is the performance of my turbine over the past week?, the system **100** calls one or more language model **120** with a description of the data sources and/or data access tools **124 - 130** which are currently available. The one or more language model **120** generate an initial plan how to respond to the user's information request, and then generate a critique of the initial plan which suggests that the turbine and performance identifiers need to be found using some of the data access tools **124** - **130** in the system **100.** The system **100** approves the initial plan and executes the data access tools **124 - 130** which use the semantically enhanced data to search for high confidence identifiers for the 'turbine' and 'performance' related data records, and find identifiers for performance dashboards, performance process data, and specific turbine assets in different data sources. The identifiers are used to query a process historian for summary time series statistics. The system **100** can serialize the results from each query as text and return the text to the one or more language model **120** for summarization.

The system **100** can return the final summarized data to the user along with any support information used to create visualizations, such as charts and hyperlinks. The visualizations provide additional information about the underlying data used to respond to the user's information request. One or more formatters are executed to respond to the user's information request, depending on the source of the data. Examples of visualizations include time series charts, summary statistics, utilization graphs, document previews, maps, custom content, etc.

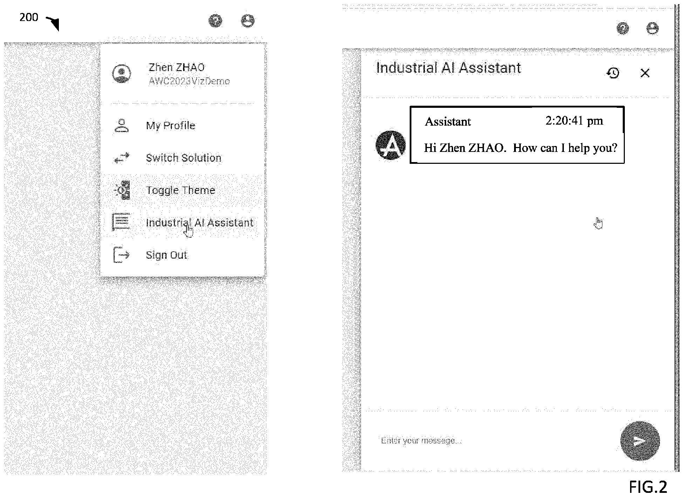

FIG. 2 depicts initiating an example chatbot session for an artificial intelligence digital assistant that retrieves and consolidates data from diverse sources, according to some embodiments. System **200** depicts a user named Zhen Zhao initiating a digital assistant chatbot session. A link to the digital assistant can be integrated into one or more products. The digital assistant can reference stored chat history initiated from different products during a chat session.

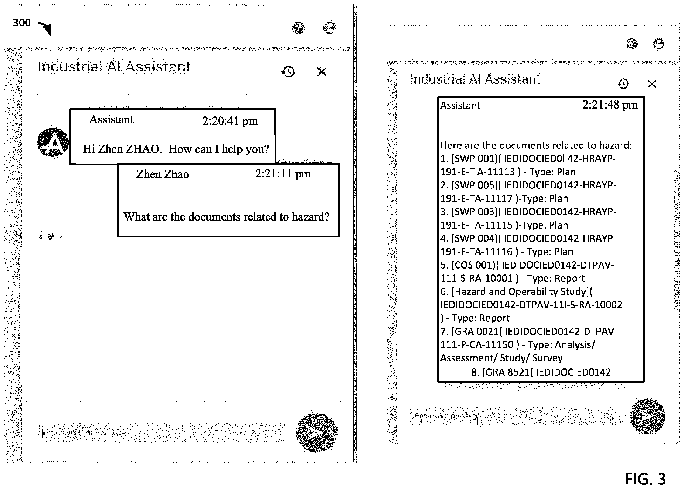

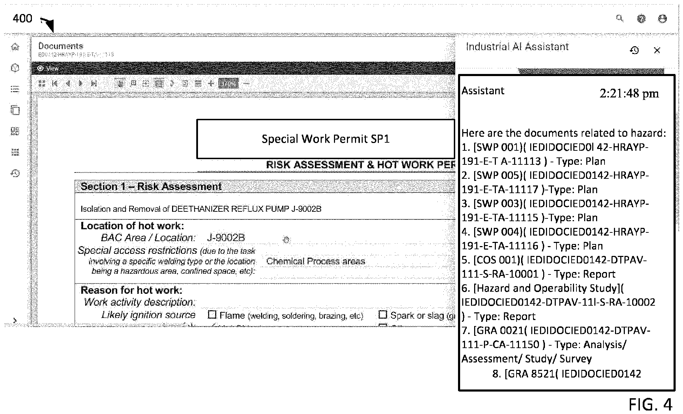

FIG. 3 depicts example retrieved and consolidated documents links in response to a user information request for an artificial intelligence digital assistant that retrieves and consolidates data from diverse sources, according to some embodiments. In this example, an information request for documents related to a hazard causes the system to return both the document name and hyperlinks to the documents. FIG. 4 depicts an example document retrieved and displayed in response to a user selection of a link for an artificial intelligence digital assistant that retrieves and consolidates data from diverse sources, according to some embodiments.

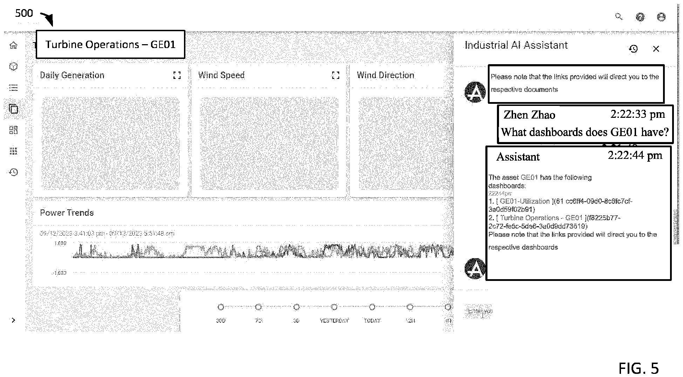

FIG. 5 illustrates example dashboards links retrieved and displayed in response to a user information request for an artificial intelligence digital assistant that retrieves and consolidates data from diverse sources, according to some embodiments. The system retrieves a list of dashboards and/or links for the dashboards associated with one or more assets, such as utilization, turbine operation, etc. The system can generate the dashboard in a graphical user interface outside the chatbot in response to a link selection. The architecture of the system **100** enables decoupling of the chatbot graphical user interface **108** from the language model **120.**

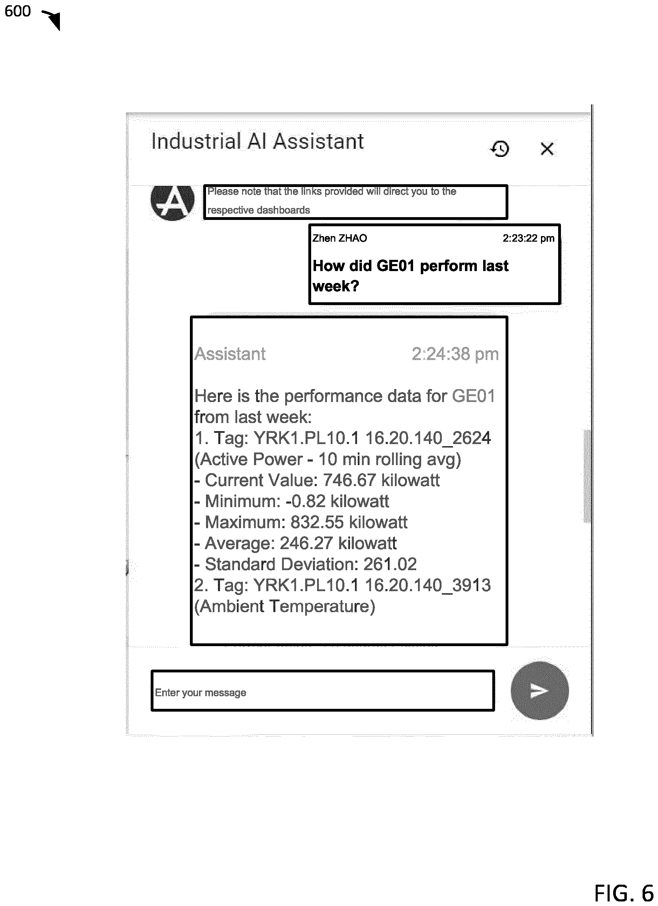

FIG. 6 illustrates an example summarization of performance for an asset for an artificial intelligence digital assistant that retrieves and consolidates data from diverse sources, according to some embodiments. Although the information request does not have any specific request for charts or tag values, the system can analyze the semantics of the user input to determine appropriate relationships between one or more tools to generate the most comprehensive response. The system can use one or more refinement of user inputs from one or more previous chat sessions to generate a response.

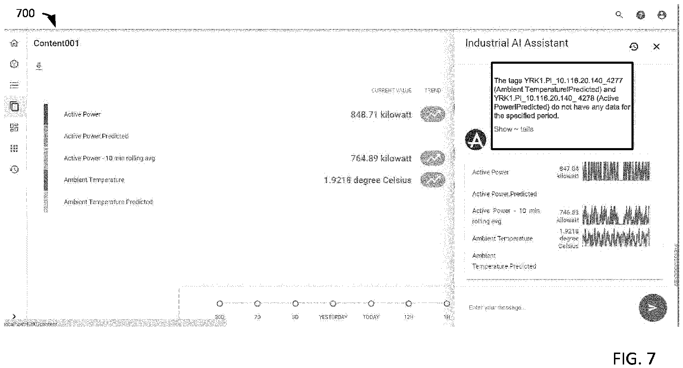

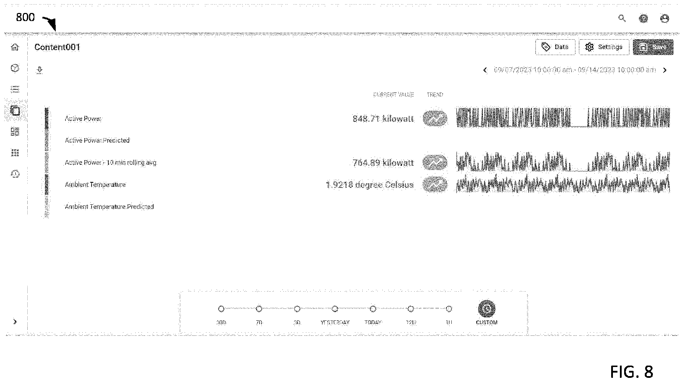

FIG. 7 depicts example visualizations of data in a chat graphical user interface for an artificial intelligence digital assistant that retrieves and consolidates data from diverse sources, according to some embodiments. The digital assistant can display one or more charts from one or more tool systems in the chat graphical user interface. FIG. 8 illustrates an example chart displayed in a chat graphical user interface for an artificial intelligence digital assistant that retrieves and consolidates data from diverse sources, according to some embodiments. The data values depicted by the chart in FIG. 8 match the data values depicted by the visualizations illustrated in FIG. 7, thereby confirming the data values previously presented to the user.

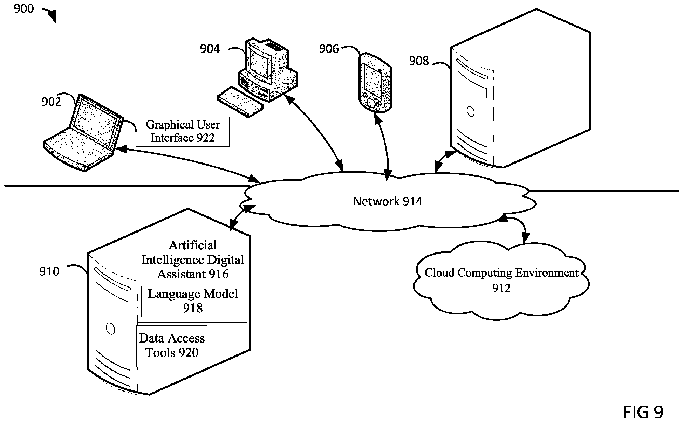

FIG. **9** illustrates a block diagram of an example system **900** for an artificial intelligence digital assistant that retrieves and consolidates data from diverse sources, under an embodiment. As shown in FIG. 9, the system **900** may illustrate a cloud computing environment in which data, applications, services, and other resources are stored and delivered through shared data centers and appear as a single point of access for the users. The system **900** may also represent any other type of distributed computer network environment in which servers control the storage and distribution of resources and services for different client users.

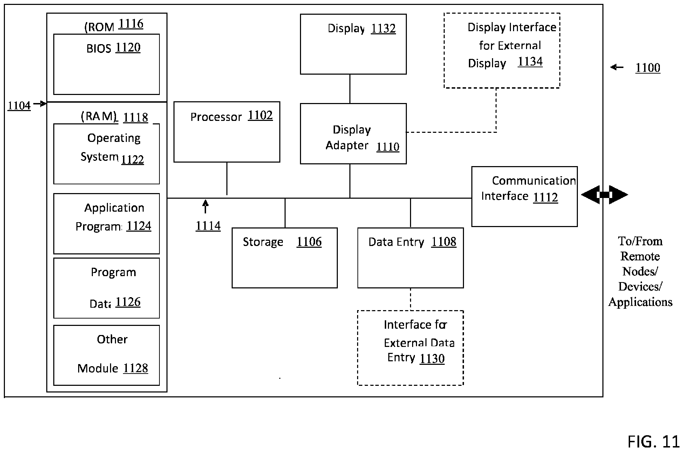

In an embodiment, the system **900** represents a cloud computing system that includes a first client **902,** a second client **904,** a third client **906,** a fourth client **908,** and a server **910** and an optional cloud computing environment **912** that may be provided by a hosting company. The clients **902** - **908,** the server **910,** and the cloud computing environment **912** communicate via a network **914.** Even though FIG. 9 depicts the first client **902** as a laptop computer **902,** the second client **904** as a desktop computer **904,** the third client **906** as a smart phone **906,** and the fourth client **908** as a server **908,** each of the system components **902** - **910** may be any type of computer system, and may each be substantially similar to the hardware device **1100** depicted in FIG. **11** and described below.

The server **910** can host and execute an artificial intelligence digital assistant **916,** which includes a language model **918** and uses data access tools **920,** and which may be accessed via a graphical user interface **922,** as depicted by Fig. 9, and/or reside on any of the clients **902** - **908.** Although FIG. 9 depicts all of the system elements **916** - **920** residing completely on the server **910,** any or all of the system elements **916** - **920** may reside completely on the clients **902** - **908,** completely on the cloud computing environment **912,** or in any combination of partially on the clients **902** - **908,** partially the server **910,** partially on the cloud computing environment **912,** and/or partially on another server which is not depicted in FIG. **9.** FIG. 9 depicts the system **900** with four clients **902** - **908,** one server **910,** one cloud computing environment **912,** one network **914,** one set of the system elements **916** - **920,** and one graphical user interface **922,** but the system **900** may include any number of clients **902** - **908,** any number of servers **910,** any number of cloud computing environment **912,** any number of network **914,** any number of system elements **916** - **920,** and any number of graphical user interface **922.**

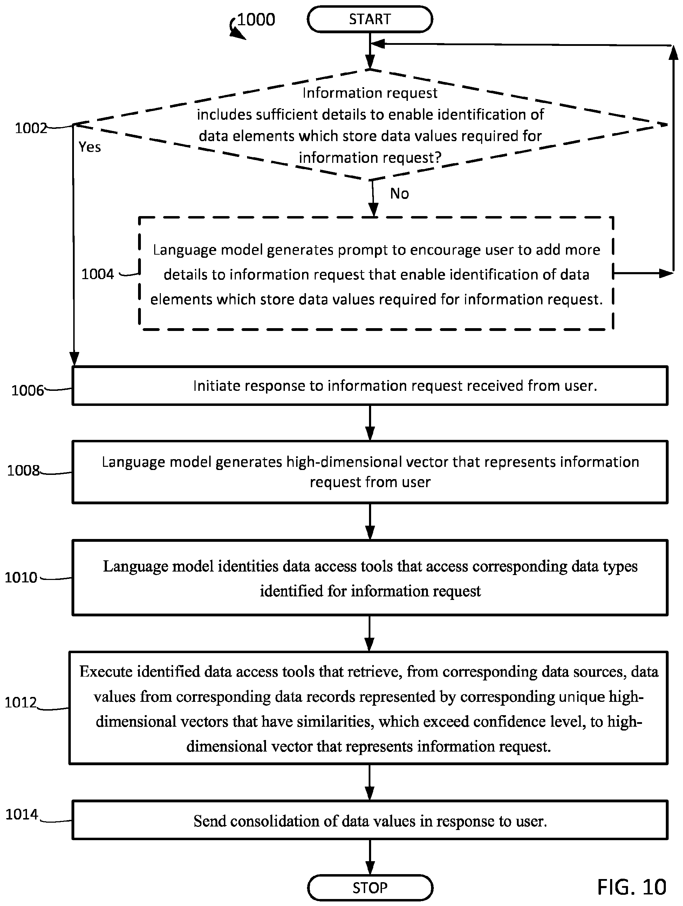

FIG. **10** is a flowchart that illustrates a computer-implemented method for an artificial intelligence digital assistant that retrieves and consolidates data from diverse sources, under an embodiment. Flowchart **1000** depicts method acts illustrated as flowchart blocks for certain actions involved in and/or between the system elements **902** - **922** of FIG. 9.

A determination is optionally made whether an information request includes sufficient details to enable identification of the data records which store the data values required for the information request, block **1002.** The system can determine whether the user provided sufficient details in an information request to retrieve the information. For example, and without limitation, this can include the language model **918** receiving a request "What is the performance of my favorite pump over the last month?" from a chat session for a user named Bill, and being unable to determine which pump Bill is referencing because Bill has not previously identified any pump as his favorite. However, during the last 30 days, Bill has frequently checked on the performance of feedwater pump 3, which is the facility's most under-performing pump. Therefore, the language model **918** reasons that Bill is probably managing a frustrating situation though humor by referring to an under-performing pump as his favorite pump, and generates a prompt based on this probability.

An information request can be an instruction to a computer to provide data. A sufficient detail can be an individual feature, fact, or item which is enough or adequate for a goal or purpose. A data record can be a composite structure or collection of fields, possibly of different types, typically fixed in number and sequence, used for storing information. A data value can be the content that is stored in a computer record.

If an information request does not include sufficient details to enable identification of the data records which store the data values required for the information request, the method **1000** continues to block **1004** to prompt the user for more details. If an information request includes sufficient details to enable identification of the data records which store the data values required for the information request, the method **1000** proceeds to block **1006** to initiate the response to the information request.

If an information request does not include sufficient details to enable identification of the data records which store the data values required for the information request, a language model optionally generates a prompt to encourage a user to add more details to the information request that enable identification of the data records which store the data values required for the information request, block **1004.** The system can prompt a user to provide sufficient details for an information request. By way of example and without limitation, this can include the language model **918** asking Bill if he wants the performance data for feedwater pump 3 because feedwater pump 3 is his "favorite" pump. Then the method **1000** returns to block **1002** to determine whether the user added sufficient details for the information request.

A language model can be a computerized representation of a system capable of human communication generation or other human communication tasks. A prompt can be a request for a computer user to provide input. A user can be a person who operates a computer. A detail can be an individual feature, fact, or item. An identification can be the action or process of establishing or indicating what something is.

A prompt may be based on common prompt descriptions for the data sources, which enables a language model to interpret an information request correctly and to facilitate processing of the data values retrieved in a standardized format. For example, since the time series data identifies pumps by the manufacture's name and model number while the alerts data identifies pumps by relative geographic location and pumping capacity, the artificial intelligence digital assistant **916** determined which identifiers referred to each pump, and created common pump descriptions that combine parts of each description, such as pump GE03. A common prompt description can be the use of standardized, normalized, and/or consistent language or vocabulary to identify different terms or terminology for the same concepts, actions, or data.

After possibly verifying the sufficiency of details in a user's information request, a response is initiated for the information request received from the user, block **1006.** The system begins creating a response to a user's information request. In embodiments, this can include the artificial intelligence digital assistant **916** receiving a request "What is the performance of pump 3 over the last month?" from a chat session for a user named Bill, and executing the language model **918** to begin the response to Bill because Bill provided sufficient details to identify the data records that store the data values that Bill requested. A response can be a written, typed, or other form of a textual answer.

Following the initiation of a response to a user's information request, a language model generates a high-dimensional vector that represents a user's information request, block 1008. The system converts an information request into a vector which is used to match the unique vectors for the data records that store the data values required for the request. For example, and without limitation, this can include the language model **918** generating the vector [-5.2, +3.1, +0.2. +8.1, +3.5, ... ] that represents Bill's information request.

A high-dimensional vector can be an array of numbers of fixed length that may be similar but not identical to another array of numbers of fixed length. High-dimensional is a term in the field of word embedding or vector embedding which indicates that a vector can have a number of dimensions that matches the number of features represented by the vector, although recent word embedding systems have developed complex techniques to reduce the number of dimensions for a high-dimensional vector without reducing the number of features. Subsequently, a human cannot generate such a high-dimensional vector, much less determine whether any of the hundreds or thousands of data records in a typical industrial facility are represented by unique high-dimensional vectors, which can have hundreds or thousands of dimensions, is similar to a high-dimensional vector that represents an information request.

Having generated a high-dimensional vector that represents an information request, a language model identities data access tools that access corresponding data types identified for the information request, block **1010.** The system identifies the types of data required for the information request and the data access tools that access these types of data. By way of example and without limitation, this can include the GPT-3 model **918** using Bill's history of previous requests for pump information which required historical operating speeds, temperatures, and pressures, alerts, and maintenance records to create a plan to execute tools to search and retrieve time series data, asset data, and event data.

A data type can be an attribute associated with a piece of information that tells a computer system how to interpret its value. A data access tool can be a resource that helps find information that can be interpreted and used by computers.

A data source may be timeseries data, engineering data, asset data event data, or data from documents or a simulation. For example, the GPT-3 model **918** identifies the data source for the timeseries data is the historical asset performance database, the data source for the asset data is the historical and scheduled maintenance database, and the data source for the event data is the production update database.

Timeseries data can be historical information related to various assets and equipment performance. Engineering data can be drawings, schematics, and technical documentation, and other information related to the design, specifications, maintenance requirements, and configurations of assets and/or equipment. Asset data can be unique identifiers, locations, maintenance history, status, current condition and/or other relevant details about products or services. Event data can be recent occurrences, significant actions, system failures, maintenance warnings, real time alerts, and/or production updates. A document can be a piece of written, printed, or electronic matter that provides information. A simulation can be an imitation of a situation or process.

After identifying the data access tools that retrieve the data types required for the information request, the identified data access tools are executed and retrieve, from corresponding data sources, data values from corresponding data records represented by corresponding unique high-dimensional vectors that have similarities, which exceed a confidence level, to the high-dimensional vector that represents the information request, block **1012.** The system retrieves data values from data records represented by unique vectors that are similar to the vector that represents the information request. In embodiments, this can include the data access tools **920** identifying unique high dimensional vectors in the data sources, such as the unique vector [-4.9, +3.6, +0.9. +7.8, +3.6, ... ] for a data record in the time series data, which are similar to the information request's high dimensional vector, and then retrieving the data values for historical operating speeds, temperatures, and pressures, alerts, and maintenance records from the data records for timeseries, assets, and events.

A data source can be the location or system where information originates from. A unique high-dimensional vector can be an array of numbers of fixed length that may be similar but not identical to another array of numbers of fixed length. A similarity can be the state or fact of resembling without being identical. A confidence level can be the probability that the value of a parameter falls within a specified range of values.

Each of the data records stored in each of the data sources is associated with metadata that is represented by a corresponding unique high-dimensional vector which is provided by a word embedding generated by a language model in a continuous vector space. For example, the third feedwater pump is assigned a unique high dimensional vector based on the pump's metadata which indicates the name of the pump's manufacturer General Electric, and the pump's relative geographic location, which is the third feedwater pump from the main entry to the industrial plant.

Metadata can be a set of information that describes other information. A word embedding can be a representation of a term as a real-valued high-dimensional vector in a continuous vector space. A continuous vector space can be a set of real-valued arrays that can be added to or multiplied by each other.

Having retrieved the data values required for the information request, a consolidation of the data values is sent in the response to the user, block **1014.** The system consolidates the data retrieved from different data sources into a single response for the user. The response may include a graphical representation and/or a visualization link, and a corresponding explanation for inclusion of the graphical representation and/or the visualization link. For example, and without limitation, this can include the digital assistant **916** displaying charts and graphs which depict the historical operating speeds, temperatures, and pressures, alerts, and maintenance records for pump GE03 in Bill's chat window **922.**

A consolidation can be the action or process of combining a number of things into a single more effective or coherent whole. A graphical representation can be a way to visually display data using charts and/or other data structures to analyze, interpret, and clarify numerical data. A visualization can be the representation of an object, situation, or set of information as a chart or other image.

A response may include additional supporting information beyond what was explicitly requested by an information request. For example, the response to Bill's request includes records of upcoming scheduled maintenance, in addition to the records of historical maintenance for feedwater pump 3. Supporting information can be secondary data that serves to corroborate the primary data.

Although FIG. **10** depicts the blocks **1002 - 1014** occurring in a specific order, the blocks **1002** - **1014** can occur in another order. In other implementations, each of the blocks **1002** - **1014** can also be executed in combination with other blocks and/or some blocks may be divided into a different set of blocks.

An exemplary hardware device in which the subject matter may be implemented shall be described. Those of ordinary skill in the art will appreciate that the elements illustrated in FIG. **11** can vary depending on the system implementation. With reference to FIG. **11****,** an exemplary system for implementing the subject matter disclosed herein includes a hardware device **1100,** including a processing unit **1102,** a memory **1104,** a storage **1106,** a data entry module **1108,** a display adapter **1110,** a communication interface **1112,** and a bus **1114** that couples elements **1104** - **1112** to the processing unit **1102.**

The bus **1114** can comprise any type of bus architecture. Examples include a memory bus, a peripheral bus, a local bus, etc. The processing unit **1102** is an instruction execution machine, apparatus, or device and can comprise a microprocessor, a digital signal processor, a graphics processing unit, an application specific integrated circuit (ASIC), a field programmable gate array (FPGA), etc. The processing unit **1102** may be configured to execute program instructions stored in the memory **1104** and/or the storage **1106** and/or received via the data entry module **1108.**

The memory **1104** can include a read only memory (ROM) **1116** and a random-access memory (RAM) **1118.** The memory **1104** may be configured to store program instructions and data during operation of the hardware device **1100.** In various embodiments, the memory **1104** can include any of a variety of memory technologies such as static random-access memory (SRAM) or dynamic RAM (DRAM), including variants such as dual data rate synchronous DRAM (DDR SDRAM), error correcting code synchronous DRAM (ECC SDRAM), or RAMBUS DRAM (RDRAM), for example.

The memory **1104** can also include nonvolatile memory technologies such as nonvolatile flash RAM (NVRAM) or ROM. It is contemplated that the memory **1104** can include a combination of technologies such as the foregoing, as well as other technologies not specifically mentioned. When the subject matter is implemented in a computer system, a basic input/output system (BIOS) **1120,** containing the basic routines that help to transfer information between elements within the computer system, such as during start-up, is stored in the ROM **1116.**

The storage **1106** can include a flash memory data storage device for reading from and writing to flash memory, a hard disk drive for reading from and writing to a hard disk, a magnetic disk drive for reading from or writing to a removable magnetic disk, and/or an optical disk drive for reading from or writing to a removable optical disk such as a CD ROM, DVD or other optical media. The drives and their associated computer-readable media provide nonvolatile storage of computer readable instructions, data structures, program modules and other data for the hardware device **1100.**

It is noted that the methods described herein may be embodied in executable instructions stored in a computer readable medium for use by or in connection with an instruction execution machine, apparatus, or device, such as a computer-based or processor-containing machine, apparatus, or device. It will be appreciated by those skilled in the art that for some embodiments, other types of computer readable media may be used which can store data that is accessible by a computer, such as magnetic cassettes, flash memory cards, digital video disks, Bernoulli cartridges, RAM, ROM, and the like can also be used in the exemplary operating environment. As used here, a "computer-readable medium" can include one or more of any suitable media for storing the executable instructions of a computer program in one or more of an electronic, magnetic, optical, and electromagnetic format, such that the instruction execution machine, system, apparatus, or device can read (or fetch) the instructions from the computer readable medium and execute the instructions for carrying out the described methods. A non-exhaustive list of conventional exemplary computer readable medium includes: a portable computer diskette; a RAM; a ROM; an erasable programmable read only memory (EPROM or flash memory); optical storage devices, including a portable compact disc (CD), a portable digital video disc (DVD), a high-definition DVD (HD-DVD^{™}), a BLU-RAY disc; and the like.

A number of program modules may be stored on the storage **1106,** the ROM **1116** or the RAM **1118,** including an operating system **1122,** one or more applications programs **1126,** program data **1126,** and other program modules **1128.** A user can enter commands and information into the hardware device **1100** through data entry module **1108.** The data entry module **1108** can include mechanisms such as a keyboard, a touch screen, a pointing device, etc.

Other external input devices (not shown) are connected to the hardware device **1100** via an external data entry interface **1110.** By way of example and not limitation, external input devices can include a microphone, joystick, game pad, satellite dish, scanner, or the like. External input devices can include video or audio input devices such as a video camera, a still camera, etc. The data entry module **1108** may be configured to receive input from one or more users of the hardware device **1100** and to deliver such input to the processing unit **1102** and/or the memory **1104** via the bus **1114.**

A display **1112** is also connected to the bus **1114** via the display adapter **1110.** The display **1112** may be configured to display output of the hardware device **1100** to one or more users. A given device such as a touch screen, for example, can function as both the data entry module **1108** and the display **1112.** External display devices can also be connected to the bus **1114** via the external display interface **1134.** Other peripheral output devices, not shown, such as speakers and printers, may be connected to the hardware device **1100.**

The hardware device **1100** can operate in a networked environment using logical connections to one or more remote nodes (not shown) via the communication interface **1112.** The remote node may be another computer, a server, a router, a peer device or other common network node, and typically includes many or all of the elements described above relative to the hardware device **1100.** The communication interface **1112** can interface with a wireless network and/or a wired network. Examples of wireless networks include, for example, a BLUETOOTH network, a wireless personal area network, a wireless 802. 21 local area network (LAN), and/or wireless telephony network (e.g., a cellular, PCS, or GSM network).

Examples of wired networks include, for example, a LAN, a fiber optic network, a wired personal area network, a telephony network, and/or a wide area network (WAN). Such networking environments are commonplace in intranets, the Internet, offices, enterprise-wide computer networks and the like. The communication interface **1112** can include logic configured to support direct memory access (DMA) transfers between the memory **1104** and other devices.

In a networked environment, program modules depicted relative to the hardware device **1100,** or portions thereof, may be stored in a remote storage device, such as, for example, on a server. It will be appreciated that other hardware and/or software to establish a communications link between the hardware device **1100** and other devices may be used.

It should be understood that the arrangement of the hardware device **1100** illustrated in FIG. **11** is but one potential implementation and that other arrangements are feasible. It should also be understood that the various system components (and means) defined by the claims, described below, and illustrated in the various block diagrams represent logical components that are configured to perform the functionality described herein. For example, one or more of these system components (and means) may be realized, in whole or in part, by at least some of the components illustrated in the arrangement of the hardware device **1100.**

In addition, while at least one of these components are implemented at least partially as an electronic hardware component, and therefore constitutes a machine, the other components may be implemented in software, hardware, or a combination of software and hardware. More particularly, at least one component defined by the claims is implemented at least partially as an electronic hardware component, such as an instruction execution machine (e.g., a processor-based or processor-containing machine) and/or as specialized circuits or circuitry (e.g., discrete logic gates interconnected to perform a specialized function), such as those illustrated in FIG. **11****.**

Consistent with the foregoing, in at least one case referred to herein as Example A-1, a system comprises: one or more processors; and a non-transitory computer readable medium storing a plurality of instructions, which when executed, cause the one or more processors to: generate, by a language model, a high-dimensional vector that represents an information request from a user, in response to initiating a response to the information request received from the user; identify, by the language model, a plurality of data access tools that access a corresponding plurality of data types identified for the information request; execute the identified plurality of data access tools that retrieve, from a corresponding plurality of data sources, a plurality of data values from a corresponding plurality of data records represented by a corresponding plurality of unique high-dimensional vectors that have similarities, which exceed a confidence level, to the high-dimensional vector that represents the information request; and send a consolidation of the plurality of data values in the response to the user.

In another case referred to herein as Example A-2, the apparatus of Example A-1, or any other exemplary embodiment described herein, may further be limited wherein: each of the plurality of data records stored in each of the plurality of data sources is associated with metadata that is represented by a corresponding unique high-dimensional vector which is provided by a word embedding generated by the language model in a continuous vector space.

In another case referred to herein as Example A-3, the apparatus of Example A-1, or any other exemplary embodiment described herein, may be further limited wherein: the plurality of instructions further causes the processor to generate, by the language model, a prompt to encourage the user to add more details to the information request that enable identification of the plurality of data records which store the plurality of data values required for the information request, in response to a determination that the information request does not include sufficient details to enable identification of the plurality of data records which store the plurality of data values required for the information request.

In another case referred to herein as Example A-4, the apparatus of Example A-3, or any other exemplary embodiment described herein, may further be limited wherein: the prompt is based on common prompt descriptions for the plurality of data sources, which enables the language model to interpret the information request correctly and to facilitate processing of the plurality of data values retrieved in a standardized format.

In another case referred to herein as Example A-5, the apparatus of Example A-1, or any other exemplary embodiment described herein, may further be limited wherein: the plurality of data sources comprise at least one of time series data, engineering data, asset data, event data, documents, and simulations.

In another case referred to herein as Example A-6, the apparatus of Example A-1, or any other exemplary embodiment described herein, may further be limited wherein: the response includes at least one of a graphical representation or a visualization link, and a corresponding explanation for inclusion of the at least one of the graphical representation or the visualization link.

In another case referred to herein as Example A-7, the apparatus of Example A-1, or any other exemplary embodiment described herein, may further be limited wherein: the response includes additional supporting information beyond what was explicitly requested by the information request.

Consistent with the foregoing, in at least one case referred to herein as Example B-1, a method comprises: generating, by a language model, a high-dimensional vector that represents an information request from a user, in response to initiating a response to the information request received from the user; identifying, by the language model, a plurality of data access tools that access a corresponding plurality of data types identified for the information request; executing the identified plurality of data access tools that retrieve, from a corresponding plurality of data sources, a plurality of data values from a corresponding plurality of data records represented by a corresponding plurality of unique high-dimensional vectors that have similarities, which exceed a confidence level, to the high-dimensional vector that represents the information request; and sending a consolidation of the plurality of data values in the response to the user.

In another case referred to herein as Example B-2, the apparatus of Example B-1, or any other exemplary embodiment described herein, may further be limited wherein: each of the plurality of data records stored in each of the plurality of data sources is associated with metadata that is represented by a corresponding unique high-dimensional vector which is provided by a word embedding generated by the language model in a continuous vector space.

In another case referred to herein as Example B-3, the apparatus of Example B-1, or any other exemplary embodiment described herein, may further be limited wherein: the computer-implemented method further comprises generating, by the language model, a prompt to encourage the user to add more details to the information request that enable identification of the plurality of data records which store the plurality of data values required for the information request, in response to a determination that the information request does not include sufficient details to enable identification of the plurality of data records which store the plurality of data values required for the information request.

In another case referred to herein as Example B-4, the apparatus of Example B-3, or any other exemplary embodiment described herein, may further be limited wherein: the prompt is based on common prompt descriptions for the plurality of data sources, which enables the language model to interpret the information request correctly and to facilitate processing of the plurality of data values retrieved in a standardized format.

In another case referred to herein as Example B-5, the apparatus of Example B-1, or any other exemplary embodiment described herein, may further be limited wherein: the plurality of data sources comprise at least one of time series data, engineering data, asset data, event data, documents, and simulations.

In another case referred to herein as Example B-6, the apparatus of Example B-1, or any other exemplary embodiment described herein, may further be limited wherein: the response includes at least one of a graphical representation or a visualization link, and a corresponding explanation for inclusion of the at least one of the graphical representation or the visualization link.

In another case referred to herein as Example B-7, the apparatus of Example B-1, or any other exemplary embodiment described herein, may further be limited wherein: the response includes additional supporting information beyond what was explicitly requested by the information request.

Consistent with the foregoing, in at least one case referred to herein as Example C-1, a computer program product, comprising: a non-transitory computer-readable medium having a computer-readable program code embodied therein to be executed by one or more processors, the program code including instructions to: generate, by a language model, a high-dimensional vector that represents an information request from a user, in response to initiating a response to the information request received from the user; identify, by the language model, a plurality of data access tools that access a corresponding plurality of data types identified for the information request; execute the identified plurality of data access tools that retrieve, from a corresponding plurality of data sources, a plurality of data values from a corresponding plurality of data records represented by a corresponding plurality of unique high-dimensional vectors that have similarities, which exceed a confidence level, to the high-dimensional vector that represents the information request; and send a consolidation of the plurality of data values in the response to the user.

In another case referred to herein as Example C-2, the apparatus of Example C-1, or any other exemplary embodiment described herein, may further be limited wherein: each of the plurality of data records stored in each of the plurality of data sources is associated with metadata that is represented by a corresponding unique high-dimensional vector which is provided by a word embedding generated by the language model in a continuous vector space.

In another case referred to herein as Example C-3, the apparatus of Example C-1, or any other exemplary embodiment described herein, may further be limited wherein: the program code includes further instructions to generate, by the language model, a prompt to encourage the user to add more details to the information request that enable identification of the plurality of data records which store the plurality of data values required for the information request, in response to a determination that the information request does not include sufficient details to enable identification of the plurality of data records which store the plurality of data values required for the information request.

In another case referred to herein as Example C-4, the apparatus of Example C-3, or any other exemplary embodiment described herein, may further be limited wherein: the prompt is based on common prompt descriptions for the plurality of data sources, which enables the language model to interpret the information request correctly and to facilitate processing of the plurality of data values retrieved in a standardized format.

In another case referred to herein as Example C-5, the apparatus of Example C-1, or any other exemplary embodiment described herein, may further be limited wherein: the plurality of data sources comprise at least one of time series data, engineering data, asset data, event data, documents, and simulations.

In another case referred to herein as Example C-6, the apparatus of Example C-1, or any other exemplary embodiment described herein, may further be limited wherein: the response includes at least one of a graphical representation or a visualization link, and a corresponding explanation for inclusion of the at least one of the graphical representation or the visualization link, or additional supporting information beyond what was explicitly requested by the information request.

Other components may be implemented in software, hardware, or a combination of software and hardware. Moreover, some or all of these other components may be combined, some may be omitted altogether, and additional components may be added while still achieving the functionality described herein. Thus, the subject matter described herein may be embodied in many different variations, and all such variations are contemplated to be within the scope of what is claimed.

In the descriptions above, the subject matter is described with reference to acts and symbolic representations of operations that are performed by one or more devices, unless indicated otherwise. As such, it is understood that such acts and operations, which are at times referred to as being computer-executed, include the manipulation by the processing unit of data in a structured form. This manipulation transforms the data or maintains it at locations in the memory system of the computer, which reconfigures or otherwise alters the operation of the device in a manner well understood by those skilled in the art. The data structures where data is maintained are physical locations of the memory that have particular properties defined by the format of the data. However, while the subject matter is described in a context, it is not meant to be limiting as those of skill in the art will appreciate that various of the acts and operations described hereinafter can also be implemented in hardware.

To facilitate an understanding of the subject matter described above, many aspects are described in terms of sequences of actions. At least one of these aspects defined by the claims is performed by an electronic hardware component. For example, it will be recognized that the various actions may be performed by specialized circuits or circuitry, by program instructions being executed by one or more processors, or by a combination of both. The description herein of any sequence of actions is not intended to imply that the specific order described for performing that sequence must be followed. All methods described herein may be performed in any suitable order unless otherwise indicated herein or otherwise clearly contradicted by context.

While one or more implementations have been described by way of example and in terms of the specific embodiments, it is to be understood that one or more implementations are not limited to the disclosed embodiments. To the contrary, it is intended to cover various modifications and similar arrangements as would be apparent to those skilled in the art. Therefore, the scope of the appended claims should be accorded the broadest interpretation so as to encompass all such modifications and similar arrangements.

## Claims

1. A system for an artificial intelligence digital assistant that retrieves and consolidates data from diverse sources, the system comprising:
one or more processors; and
a non-transitory computer readable medium storing a plurality of instructions, which when executed, cause the one or more processors to:
generate, by a language model, a high-dimensional vector that represents an information request from a user, in response to initiating a response to the information request received from the user;
identify, by the language model, a plurality of data access tools that access a corresponding plurality of data types identified for the information request;
execute the identified plurality of data access tools that retrieve, from a corresponding plurality of data sources, a plurality of data values from a corresponding plurality of data records represented by a corresponding plurality of unique high-dimensional vectors that have similarities, which exceed a confidence level, to the high-dimensional vector that represents the information request; and
send a consolidation of the plurality of data values in the response to the user.

2. The system of claim 1, wherein each of the plurality of data records stored in each of the plurality of data sources is associated with metadata that is represented by a corresponding unique high-dimensional vector which is provided by a word embedding generated by the language model in a continuous vector space.

3. The system of claim 1, wherein the plurality of instructions further causes the processor to generate, by the language model, a prompt to encourage the user to add more details to the information request that enable identification of the plurality of data records which store the plurality of data values required for the information request, in response to a determination that the information request does not include sufficient details to enable identification of the plurality of data records which store the plurality of data values required for the information request.

4. The system of claim 3, wherein the prompt is based on common prompt descriptions for the plurality of data sources, which enables the language model to interpret the information request correctly and to facilitate processing of the plurality of data values retrieved in a standardized format.

5. The system of claim 1, wherein the plurality of data sources comprise at least one of time series data, engineering data, asset data, event data, documents, and simulations.

6. The system of claim 1, wherein the response includes at least one of a graphical representation or a visualization link, and a corresponding explanation for inclusion of the at least one of the graphical representation or the visualization link.

7. The system of claim 1, wherein the response includes additional supporting information beyond what was explicitly requested by the information request.

8. A computer-implemented method for an artificial intelligence digital assistant that retrieves and consolidates data from diverse sources, the computer-implemented method comprising:
generating, by a language model, a high-dimensional vector that represents an information request from a user, in response to initiating a response to the information request received from the user;
identifying, by the language model, a plurality of data access tools that access a corresponding plurality of data types identified for the information request;
executing the identified plurality of data access tools that retrieve, from a corresponding plurality of data sources, a plurality of data values from a corresponding plurality of data records represented by a corresponding plurality of unique high-dimensional vectors that have similarities, which exceed a confidence level, to the high-dimensional vector that represents the information request; and
sending a consolidation of the plurality of data values in the response to the user.

9. The computer-implemented method of claim 8, wherein each of the plurality of data records stored in each of the plurality of data sources is associated with metadata that is represented by a corresponding unique high-dimensional vector which is provided by a word embedding generated by the language model in a continuous vector space.

10. The computer-implemented method of claim 8, wherein the computer-implemented method further comprises generating, by the language model, a prompt to encourage the user to add more details to the information request that enable identification of the plurality of data records which store the plurality of data values required for the information request, in response to a determination that the information request does not include sufficient details to enable identification of the plurality of data records which store the plurality of data values required for the information request.

11. The computer-implemented method of claim 10, wherein the prompt is based on common prompt descriptions for the plurality of data sources, which enables the language model to interpret the information request correctly and to facilitate processing of the plurality of data values retrieved in a standardized format.

12. The computer-implemented method of claim 8, wherein the plurality of data sources comprise at least one of time series data, engineering data, asset data, event data, documents, and simulations.

13. The computer-implemented method of claim 8, wherein the response includes at least one of a graphical representation or a visualization link, and a corresponding explanation for inclusion of the at least one of the graphical representation or the visualization link.

14. The computer-implemented method of claim 8, wherein the response includes additional supporting information beyond what was explicitly requested by the information request.

15. A computer program product, comprising a non-transitory computer-readable medium having a computer-readable program code embodied therein to be executed by one or more processors, the program code including instructions to:
generate, by a language model, a high-dimensional vector that represents an information request from a user, in response to initiating a response to the information request received from the user;
identify, by the language model, a plurality of data access tools that access a corresponding plurality of data types identified for the information request;
execute the identified plurality of data access tools that retrieve, from a corresponding plurality of data sources, a plurality of data values from a corresponding plurality of data records represented by a corresponding plurality of unique high-dimensional vectors that have similarities, which exceed a confidence level, to the high-dimensional vector that represents the information request; and
send a consolidation of the plurality of data values in the response to the user.

16. The computer program product of claim 15, wherein each of the plurality of data records stored in each of the plurality of data sources is associated with metadata that is represented by a corresponding unique high-dimensional vector which is provided by a word embedding generated by the language model in a continuous vector space.

17. The computer program product of claim 15, wherein the program code includes further instructions to generate, by the language model, a prompt to encourage the user to add more details to the information request that enable identification of the plurality of data records which store the plurality of data values required for the information request, in response to a determination that the information request does not include sufficient details to enable identification of the plurality of data records which store the plurality of data values required for the information request.

18. The computer program product of claim 17, wherein the prompt is based on common prompt descriptions for the plurality of data sources, which enables the language model to interpret the information request correctly and to facilitate processing of the plurality of data values retrieved in a standardized format.

19. The computer program product of claim 15, wherein the plurality of data sources comprise at least one of time series data, engineering data, asset data, event data, documents, and simulations.

20. The computer program product of claim 15, wherein the response includes at least one of a graphical representation or a visualization link, and a corresponding explanation for inclusion of the at least one of the graphical representation or the visualization link, or additional supporting information beyond what was explicitly requested by the information request.
